# EUROPEAN PATENT SPECIFICATION

(11) **EP 2 434 529 B1**
(45) Date of publication and mention of the grant of the patent: **12.02.2020**
(21) Application number: 10181355.8
(22) Date of filing: 28.09.2010
(51) Int. Cl.: C23C 16/40, H01L 21/314, C23C 16/455, H01L 21/02, H01L 49/02

(54) **Metal-insulator-metal capacitor for use in semiconductor devices and manufacuring method therfor**
Metall-Isolator-Metall-Kondensator zur Verwendung in Halbleitervorrichtungen und Herstellungsverfahren dafür
Condensateur métal-isolant-métal pour l'utilisation dans des dispositifs semi-conducteurs et son procédé de fabrication

(43) Date of publication of application: 28.03.2012
(73) Proprietor: IMEC VZW, 3001 Leuven (BE)
(72) Inventor: Popovici, Mihaela Ioana, 3000 Leuven (BE); Swerts, Johan, 3010 Kessel-Lo (BE); Kittl, Jorge, 1320 Hamme-Mille (BE); Van Elshocht, Sven, 3001 Leuven (BE)
(74) Representative: Pronovem

(56) References cited:
- US-A1- 2003 011 012
- US-A1- 2005 009 369
- US-A1- 2006 151 823
- US-A1- 2007 141 778
- US-A1- 2009 134 445
- US-A1- 2009 297 696

## Description

### Field of the Invention

The present invention is related to the production of metal-insulator-metal capacitor (MIMCAP) structures for use in semiconductor devices. The main application is the use of MIMCAPs in random-access memory such as DRAM devices.

### State of the art.

For future scaling of a DRAM metal-insulator-metal capacitor (MIMCAP) a dielectric with a k-value higher than the k-value given by Al₂O₃ (∼9) and/or ZAZ (ZrO₂/Al₂O₃/ZrO₂) (∼40) is required. A second requirement is that the metal electrode does not contribute to the Equivalent Oxide Thickness (EOT) due to the oxidation of its top surface. Therefore, one of the promising metals to replace TiN in conventional MIMCAPs is ruthenium (Ru). Even if it is further oxidized at the top surface, RuO₂ will show metal-like conductive behaviour and as such not contribute to the EOT.

Both high-k and metal layers are preferably deposited by Atomic Layer Deposition (ALD) or Chemical Vapour Deposition (CVD) to ensure good step coverage in high aspect ratio structures. ALD of high-k dielectric layers often uses ozone (O₃) as oxidant.
The k-value of the high-k dielectrics often depends on the crystalline structure of the material. TiO₂ in its rutile form has been reported to have a k-value of ∼80 while only ∼40 in its anatase phase. It is however not easy to grow TiO₂ in its rutile phase by ALD. It prefers to form anatase TiO₂. Only after high temperature anneal it transforms to rutile TiO₂. In MIMCAP applications, anneal temperatures of maximum 650-700°C are applied due to susceptibility to oxidation of the top and bottom electrodes. Commonly, rutile is only obtained above 750°C.

TiO₂ as grown on TiN by ALD is found to be either amorphous or crystallized in the anatase phase. The phase is maintained up to at least 700°C. When O₃ is used instead of H₂O as oxidant at similar process conditions (temperature), crystalline phase formation during deposition is favoured since O₃ is a stronger oxidant. For that reason O₃ is preferred as oxidant. It was also reported that when using Ru as bottom electrode, rutile TiO₂ was obtained on Ru when using O₃ as oxidant in the ALD TiO₂ process at 250°C, see for example the document High dielectric constant TiO₂ thin films on a Ru electrode grown at 250°C by atomic-layer deposition, Kim et al, Appl. Phys. Lett., 85, 4112 (2004) .

Rutile phase TiO₂ can be obtained when using a crystalline template approach, such as tetragonal RuO₂ due to an excellent match in crystal structure between rutile tetragonal TiO₂ (lattice parameters: a=b=4.59 Å, c=2.96 Å) and tetragonal RuO₂ (lattice parameters: a=b=4.50 Å, c=3.10 Å). This is has been reported by Fröhlich et al, in document Epitaxial growth of high-k TiO2 rutile films on RuO2 electrodes, Electrochem. Solid-State Lett., 11, G19(2008).

However, it is also reported that O₃ and Ru are not compatible. Ru is instantly etched when Ru is exposed to O₃ (see document Etching technique for ruthenium with a high etch rate and high selectivity using O₃ gas, Nakahara et al, Journal of Vacuum Science And Technology B, 19, 2133(2001). On the contrary, RuO₂ is known to be much less reactive with O₃.

In conclusion: without protection, Ru substrates are not compatible with O₃ based high-k deposition processes. Practical etching and roughening of the surface will take place at the initial stage of the high-k deposition. Similar problems may occur with metals other than Ru. Also when the metal is not etched by O₃, O₃ exposure will oxidize the metal and if the metal oxide is not metal-like, it will give rise to a EOT contribution and higher resistivity.

Document US2009/0134445 is related to a MIMCAP structure including a bottom electrode obtained by ALD or CVD deposition of Ru, and a dielectric comprising a TiO₂ layer in rutile phase. Between the Ru electrode and the TiO₂ layer, an Al₂O₃ layer is provided, obtained by ALD and with O₃ or H₂O as oxidant. The function of the Al₂O₃ layer is to prevent deterioration of the interfacial characteristics between the bottom electrode and the TiO₂ layer and to prevent oxidation of the bottom electrode. The TiO₂ layer is obtained by ALD using O₃ as the reactive component. A problem is that Al₂O₃ does not form an optimal template for growing TiO₂ in rutile form. After ALD deposition of the TiO₂ layer, an oxidation plasma treatment or oxygen ion beam irradiation treatment is required for changing portions of TiO₂ which had not grown in rutile form. Also, Al₂O₃ has a moderate k-value of about 9, and the protective layer will give an unacceptable contribution to the EOT.

Another problem in existing techniques is that low roughness of the Ru layer is not maintained when a Ru/RuO₂ is produced by oxidation of the Ru layer. Current oxidation techniques for obtaining a RuO₂ layer on top of the Ru, such as oxidation by O₃ treatment or subjecting the Ru-layer to an O₂ anneal, tend to increase the roughness of the substrate, because of unwanted etching by O₃ or because of the localized formation of RuO₂ crystals. There is currently no oxidation technique for Ru which preserves the smoothness of the Ru-surface.

Document US2006/0151823 is related to a method for forming a capacitor comprising the deposition by AID of a dielectric layer on a metal bottom electrode, the dielectric layer being formed of a stack of a first dielectric layer (e.g. TiO₂), a second dielectric layer (e.g. Al₂O₃), and again at least one sequence of the first and second dielectric layers. The layers can be subjected to an anneal so as to form a mixed compound.

Document US2007/0141778 is related to a metal-insulator-metal capacitor comprising a bottom an top electrode, and therebetween a dielectric layer comprising several TiO₂ layers at least one tetragonal structure layer disposed between two TiO₂ layers.

Document US2009/0297696 is related to the deposition of conductive titanium oxide films by ALD processes. The disclosed method involves the deposition of a doped titanium oxide film by subsequent and alternating ALD cycles of titanium oxide and dopant oxides. This is followed by the deposition of a high-k layer such as PbTiO₃ or SrTiO₃. The document also describes the use of this method for producing capacitor structures. Examples are described where a TiNbO layer is obtained by alternating ALD depositions of TiO₂ and Nb₂O₅, followed by an anneal in a forming gas (5%H₂, 95%N₂). In one of the examples, the thickness of the conductive TiNbO film ranges from 44nm for undoped TiO₂ to 94nm for heavily doped TiNbO films.

Document US2005/0009369 is related to a method for forming a multi-layered structure by two subsequent ALD steps, thereby forming a first and second dielectric metal oxide film. The method can be applied on a bottom electrode to produce a capacitor. The first metal oxide film is deposited with H₂O as the oxidant, the second using O₃ as the oxidant. Both the first and second metal oxide can be titanium oxide. The thickness of the first metal oxide film is not specified.

### Summary of the invention

The invention is related to methods as described in the appended claims. In particular the invention is related to a method for producing a stack of layers on a semiconductor substrate, the method comprising the steps of :
- Providing a substrate,
- producing on said substrate a first metal layer, or a first metal layer covered by an oxide of said metal,
- By atomic layer deposition, depositing on said first metal layer or on said oxide a protection layer of TiO₂, wherein H₂O is used as the oxidant during the ALD deposition,
- By atomic layer deposition, depositing on said TiO₂ layer, a layer of a dielectric material, wherein O₃ is used as the oxidant during the ALD deposition, to thereby obtain a stack of a TiO₂ layer and a second dielectric layer,
- Depositing a second metal layer on said dielectric material layer.

The first metal layer consists of or comprises on its top surface a Ru layer or a Ru layer covered by ruthenium oxide.

The second dielectric layer is a layer of TiO₂ in rutile phase.

The protective TiO₂ layer has a thickness lower than 1nm.

The above method may further comprise the step of depositing said first metal layer on the substrate, followed by the step of oxidising the first metal layer prior to deposition of the TiO₂ protection layer, so as to obtain a metal oxide layer on top of the metal layer, wherein said step of oxidising takes place by subjecting the metal layer to an atmosphere consisting of O₂ or of a mixture of O₂ and one or more inert gases, with the total or partial pressure of O₂ between 0.13Pa and 1333.22Pa, at a temperature between 200°C and 450°C, during an oxidation time between 1min and 30min. The above cited partial pressure, temperature and oxidation time are such that the roughness of the metal oxide layer is substantially equal to the roughness of the first metal layer.

The method preferably further comprises process steps to produce one or more metal-insulator-metal capacitor structures on the substrate.

### Brief description of the figures

Figure 1 shows the various steps of the method according to a first embodiment of the invention.
Figure 2a shows the layer thickness of a Ru-layer which is initially 5nm thick and of the RuO₂ layer formed on said Ru-layer, as a function of the oxidation time, in an oxidation process according to the invention, at two different temperatures.
Figure 2b shows the RMS roughness value of the RuO₂ layer obtained by the oxidation process according to the invention, as a function of the oxidation time, at two different temperatures.
Figure 3 shows a MIMCAP structure obtainable by the method depicted in figure 1.
Figure 4 shows a MIMCAP structure obtainable by the method according to a second embodiment of the invention.

### Detailed description of the invention

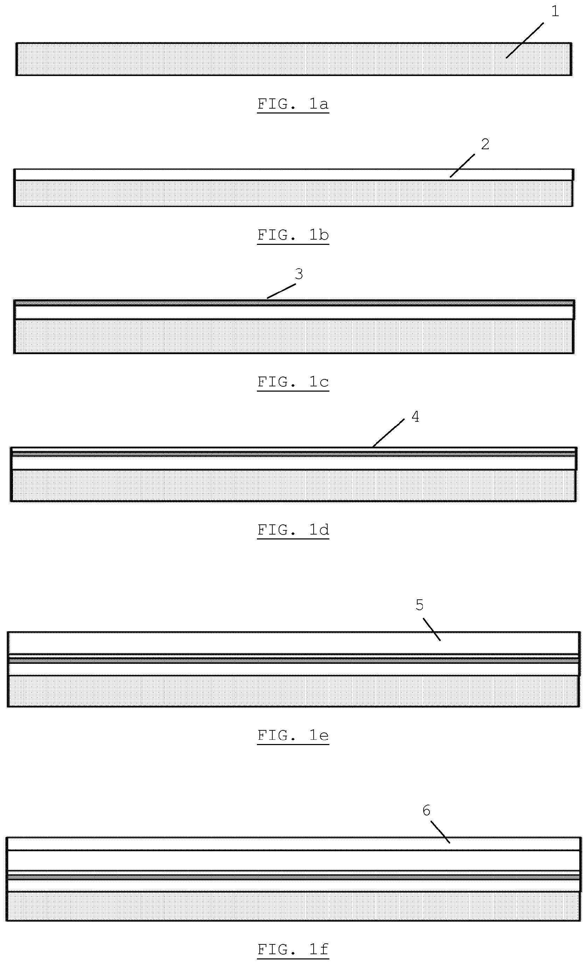

With reference to figures 1a to 1f, the method of the invention according to a first preferred embodiment is described hereafter. First a substrate 1 is provided, for example a silicon substrate comprising bit lines and transistors (not shown). Then a Ru layer 2 is deposited onto the substrate. The deposition of Ru may take place by Atomic Layer Deposition (ALD), possibly by Plasma Enhanced ALD (PEALD), or by CVD. Possibly a layer of TiN is first deposited on the substrate, and the Ru layer is deposited onto the TiN layer. For example, a 10nm layer of TiN may be deposited followed by a 5nm Ru layer.

The Ru-layer 2 is then subjected to a controlled oxidation method. Ruthenium oxidation may be performed in a cross-flow-type ALD reactor at 250°C with formation of a ∼ 1-1.5 nm Ruthenium oxide thin film 3. In the present description, Ruthenium oxide is to be understood as RuOₓ with a tetragonal crystal structure, having a mismatch with rutile TiO₂ of not more than 2%. This means that the value of x is substantially equal to 2. Small deviations from this value 2 are allowed as long as the above mismatch remains within the 2% limit. In the rest of this description, the thus described Ru-oxide will be referred to as RuO₂. According to a particular preferred embodiment, the substrate comprising the Ru-layer (as shown in fig. 1b) is subjected to a low-pressure atmosphere consisting of O₂ or consisting of a mixture of O₂ and one or more inert gases such as N₂. The pressure or partial pressure of O₂ is between 1mTorr and 10 Torr (i.e. between 0.13Pa and 1333.22Pa). The temperature during oxidation is between 200°C and 450°C. The oxidation time is between 1min and 30min, with lower oxidation times being applicable for higher temperatures. The invention reveals that under these oxidation conditions, it is possible to obtain a RuO₂ layer 3 on the Ru layer, wherein the roughness of the RuO₂ layer is substantially equal to the roughness of the original Ru-layer.

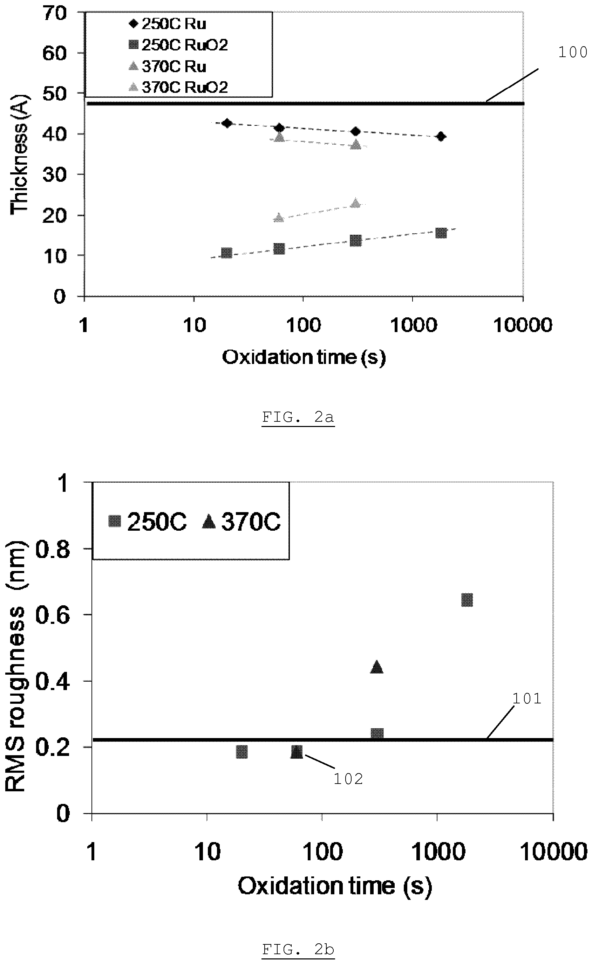

Test results are illustrated in figures 2a and 2b, which are valid for a low pressure atmosphere at 1Torr total pressure, consisting of O₂ and N₂ with O₂ at a partial pressure of 0.2Torr. Figure 2a shows the thickness of the RuO₂ layer obtained at 250°C and 370°C, as a function of the oxidation time. Depending on the temperature and oxidation time, the RuO₂ thickness is between 1nm and 2nm. Line 100 represents the initial thickness of the Ru-layer prior to oxidation. Figure 2b shows the RMS roughness value as a function of the oxidation time, compared to the initial Ru-roughness 101. Measurement point 102 is valid for 250°C and 370°C (square and triangle are coinciding). It can be derived from these results that at a temperature of 250°C, the oxidation time is preferably lower than about 10min in order to maintain the roughness at substantially the same value. At 370°C, the oxidation time is preferably lower than about 5min. In all of the present description, the unit Torr is to be calculated towards the SI unit Pa as follows : 1Torr = 133.32 Pa.

The invention thus defines a window in terms of oxidation time and temperature which allows the formation of a RuO₂ layer with substantially the same RMS value of the initial Ru layer. The formation of such a RuO₂ layer is beneficial for the subsequent growing of rutile phase TiO₂ due to the matching crystal structure of RuO₂ and rutile TiO₂. The low roughness of the RuO₂ layer is beneficial for the surface uniformity of the layers deposited on said RuO₂ layer.

After the oxidation step, a first layer 4 of TiO₂ is deposited by ALD. The steps of depositing any oxide layer by ALD in the method of the invention are known per se and may be executed in a known tool suitable for ALD, such as a cross-flow-type ALD reactor. ALD deposition of the first TiO₂ layer 4 takes place through a number of deposition cycles performed on the substrate in a reactor chamber, each cycle comprising the steps of :
- providing a Ti-precursor onto the surface of the substrate, e.g. Ti(OCH₃)₄,
- Purging the reaction chamber, e.g. by a flow of N₂-gas,
- Adding H₂O as the oxidant in vapour form,
- Purging the reaction chamber, e.g. again by N₂.

The deposition temperature is preferably about 250°C. The pressure is preferably between 1 and 3Torr. The duration of the four steps may be as follows : 2s/4s/4s/8s. Such ALD parameters lead to a growth per cycle of about 0.04nm per cycle.

The thickness of the first TiO₂ layer 4 is lower than 1nm, more preferably lower than 0.6nm.

In a second ALD deposition step, a second TiO₂ layer 5 is deposited by a repetition of the following cycle :
- Adding a Ti-precursor onto the surface of the substrate, e.g. Ti(OCH₃)₄,
- Purging the reaction chamber, e.g. by a flow of N₂-gas,
- Adding O₃-gas as the oxidant,
- Purging the reaction chamber, e.g. again by N₂.

In the deposition of the second TiO₂ layer, the deposition temperature is preferably about 250°C, at a pressure preferably between 1 and 3Torr. The duration of the four steps may be as follows : 4s/5s/4s/8s. The thickness of the second TiO₂ layer 5 may differ according to the application. For the production of MIMCAPs, the thickness of this layer is preferably between 5nm and 20nm. During or after the second ALD step, dopants may be added to the second TiO₂ layer, according to known doping methods. The dopant may be chosen from the group consisting of : Sr, Ta, Al, Hf, Gd, Zr, Sc, Dy.

The combined RuO₂ layer 3 and first TiO₂ layer 4 enhance the protection of the Ru from etching during the subsequent ALD/O₃ deposition step. Furthermore, because the first TiO₂ layer 4 is thinner than 1nm, the RuO₂ crystal structure is transferred onto the thin TiO₂ layer and rutile TiO₂ is more easily formed during deposition of the second TiO₂ layer 5 under O₃, due to the matching RuO₂ and rutile TiO₂ structure.

Finally, a second metal layer 6 is deposited on top of the second TiO₂ layer 4. The second metal layer may be a Ru or a TiN layer or any other suitable layer. The deposition technique for producing the first and second metal layers may be according to any known technique for the production of MIMCAP structures.

According to a second embodiment, the controlled oxidation step of the Ru layer is omitted and the first TiO₂ layer is deposited directly on the Ru layer, by the method steps described above for deposition of the first TiO₂ layer, i.e. ALD with H₂O as the oxidant. This first TiO₂ layer forms a protection of the Ru-layer against oxidation of Ru by subsequent ALD steps using O₃ as the oxidant. The second TiO₂ layer may then be deposited according to the steps described above for depositing the second TiO₂ layer, i.e. ALD with O₃ as oxidant. In this embodiment, the second TiO₂ layer may not or may not entirely be in rutile phase, because of the absence of the RuO₂ layer. The advantage of protecting the Ru layer from etching by O₃ is however maintained.

In the method of the invention, any other metal may be used instead of Ru for the deposition of the first metal layer, which will eventually serve as the bottom electrode of the MIMCAP. Preferably a metal is used of which the oxide has metallic characteristics so as not to contribute to the EOT. An example of such a metal is molybdenum. Also, another dielectric may be deposited in stead of the second TiO₂ layer especially in the second embodiment wherein no oxidation of the Ru is performed, so that the intermediate TiO₂ layer works as a protection layer but not as a template for growing a layer of matching microstructure. For example Al₂O₃, Titanium Aluminium oxide, ZrO₂, HfO₂, Strontium Titanium oxide or other high-k dielectrics may be used as the second dielectric layer, deposited by ALD with O₃ as the oxidant.

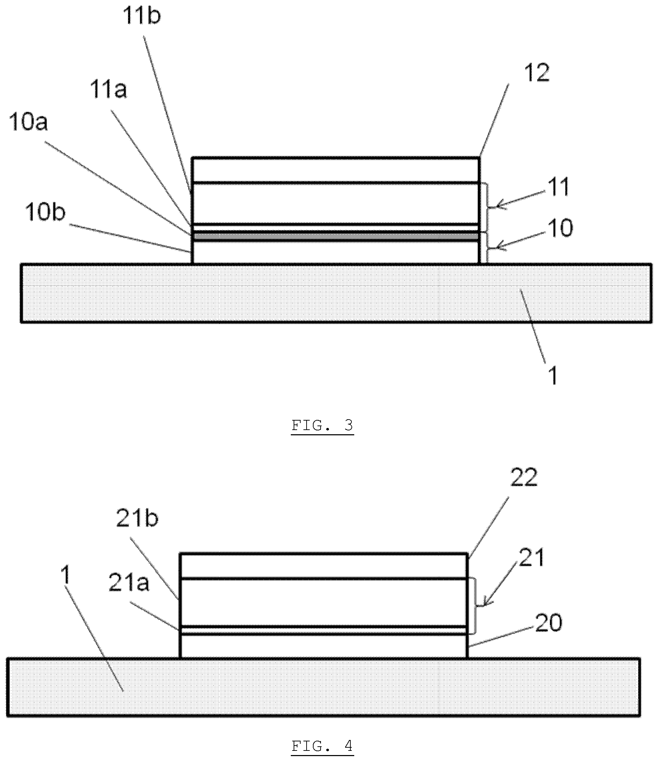

A metal-insulator-metal capacitor obtainable by the method according to the first embodiment, followed by known fabrication steps is shown in figure 3. It comprises a bottom electrode 10 having at least at its top surface a Ru layer 10a and a RuO₂ layer 10b between 1 and 2nm thick, a dielectric layer 11 consisting of a first intermediate TiO₂ layer 11a of maximum 1nm thickness and a second dielectric layer 11b, and a top electrode 12. The structure of the intermediate TiO₂ is defined by the RuO₂ layer underneath, which is similar to the structure of rutile TiO₂, and therefore suitable for growing rutile TiO₂ in the second deposition step. When the second dielectric is rutile phase TiO₂, the first and second TiO₂ layer may not be distinguishable in the final product.

A MIMCAP obtainable by the method according to the second embodiment is shown in figure 4. The MIMCAP comprises a bottom electrode 20 having at least at its top surface a Ru layer, a dielectric layer 21 consisting of a first intermediate TiO₂ layer 21a lower than 1nm in thickness and a second dielectric layer 21b (for example rutile TiO₂ or another dielectric), and a top electrode 22. If the second dielectric is different from TiO₂, the intermediate layer TiO₂ can be detected in the end product.

The invention is also related to a semiconductor wafer comprising the stack of layers as obtained by the method of the invention, for example the wafer shown in figure If.

### Examples - test results

Tests were done to obtain atomic layer deposition of rutile TiO₂ crystalline at 250°C on oxidized ruthenium. The layers were characterized by spectroscopic ellipsometry (SE), X-ray reflectometry (XRR), X-ray diffraction (XRD), scanning electron microscopy (SEM), transmission electron microscopy (TEM), time of flight (TOF) - secondary ion mass spectrometry (SIMS), capacitance - voltage (C- V), and current density - voltage (J - V). Films were grown in a cross flow-type ALD reactor on 1.5nm RuO₂/4nm Ru/10nm TiN/Si(100) wafers (300 mm diameter) at 250°C using Ti(OCH₃)₄ and O₃ and/or H₂O as oxidant. To compare, ALD TiO₂ films were grown as well on 10 nm PVD TiN/20nm SiO₂/Si(100) substrates. TiO₂ shows a self-limiting growth with H₂O or O₃ as oxidant and a similar growth per cycle (GPC) i.e. ∼ 0.04 nm/cycle. On the other hand, clear differences in microstructure can be observed between H₂O and O₃, as function of starting surface. Grazing incidence XRD (GIXRD) measurement showed that TiO₂ grown on TiN was amorphous using a H₂O based process or anatase for an O₃ based process due to stronger oxidant potential of O₃.

With Ru as a substrate, TiO₂ was again amorphous grown with H₂O, but was rutile using O₃. Finally, on RuO₂/Ru, a water based process led to anatase formation while TiO₂ with O₃ formed rutile as well. The formation of rutile TiO₂ for both Ru and RuO₂ as substrate for the O₃ based process is due to the formation of RuO₂ already during the first O₃ pulses. Important to note is that in both cases (Ru and RuO₂/Ru) using O₃ as oxidant, part of the Ru bottom electrode was heavily etched down to the TiN underlayer resulting in a highly non-uniform layer. To prevent this, an etch stop layer of ∼ 0.3 nm TiO₂ using H₂O was deposited before the remainder of the bulk of TiO₂ layer using an O₃ based process. Wafer ellipsometry map or Ru layer clearly showed the beneficial effect of this intermediate layer. The H₂O based part of the process prevented the etching, while the O₃ yielded the highly wanted rutile phase.

## Claims

1. A method for producing a stack of layers on a semiconductor substrate, the method comprising the steps of :
• Providing a substrate (1),
• producing on said substrate a first metal layer (2), or a first metal layer covered by an oxide of said metal,
• By atomic layer deposition, depositing on said first metal layer or on said oxide a protection layer (3) of TiO₂, wherein H₂O is used as the oxidant during the ALD deposition,
• By atomic layer deposition, depositing on said TiO₂ layer, a layer of a dielectric material, wherein O₃ is used as the oxidant during the ALD deposition, to thereby obtain a stack of a TiO₂ layer and a second dielectric layer,
• Depositing a second metal layer on said dielectric material layer,
**characterized in that** said protection TiO₂ layer has a thickness lower than 1nm, and wherein :
• the first metal layer consists of or comprises on its top surface a Ru layer or a Ru layer covered by ruthenium oxide,
• the second dielectric layer is a layer of TiO₂ in rutile phase.

2. Method according to claim 1, wherein one or more dopants are added to the second dielectric layer, said dopants being chosen from the group consisting of : Sr, Ta, Al, Hf, Gd, Zr, Sc, Dy.

3. Method according to claim 1 or 2, comprising the step of depositing said first metal layer on the substrate, followed by the step of oxidising the first metal layer prior to deposition of the TiO₂ protection layer, so as to obtain a metal oxide layer on top of the metal layer, wherein said step of oxidising takes place by subjecting the metal layer to an atmosphere consisting of O₂ or of a mixture of O₂ and one or more inert gases, with the total or partial pressure of O₂ between 0.13Pa and 1333.22Pa, at a temperature between 200°C and 450°C, during an oxidation time between 1min and 30min.

4. Method according to any one of the preceding claims, further comprising process steps to produce one or more metal-insulator-metal capacitor structures on the substrate.

## Patentansprüche

1. Verfahren zum Herstellen eines Stapels von Lagen auf einem Halbleitersubstrat, wobei das Verfahren die Schritte umfasst:
• Bereitstellen eines Substrats (1),
• Herstellen einer ersten Metalllage (2) oder einer ersten Metalllage, die von einem Oxid des besagten Metalls bedeckt ist, auf dem Substrat,
• Abscheiden einer Schutzlage (3) aus TiO₂ durch Atomlagenabscheidung auf der besagten ersten Metalllage oder auf dem besagten Oxid, wobei H₂O als Oxidationsmittel während der ALD-Abscheidung verwendet wird,
• Abscheiden einer Lage aus einem dielektrischen Material durch Atomlagenabscheidung auf der besagten TiO₂-Lage, wobei O₃ als Oxidationsmittel während der ALD-Abscheidung verwendet wird, um dadurch einen Stapel aus einer TiO₂-Lage und einer zweiten dielektrischen Lage zu erhalten,
• Abscheiden einer zweiten Metalllage auf der besagten Lage aus dielektrischem Material,
**dadurch gekennzeichnet, dass** die TiO₂-Schutzlage eine Dicke von weniger als 1 nm aufweist, und wobei:
• die erste Metalllage auf ihrer Deckfläche aus einer Ru-Lage oder einer Ru-Lage, die von Rutheniumoxid bedeckt ist, besteht oder diese umfasst,
• die zweite dielektrische Lage eine Lage aus TiO₂ in Rutilphase ist.

2. Verfahren nach Anspruch 1, wobei ein oder mehrere Dotiermittel zu der zweiten dielektrischen Lage hinzugefügt werden, wobei die Dotiermittel aus der Gruppe ausgewählt sind, bestehend aus: Sr, Ta, Al, Hf, Gd, Zr, Sc, Dy.

3. Verfahren nach Anspruch 1 oder 2, das den Schritt des Abscheidens der besagten ersten Metalllage auf dem Substrat und danach den Schritt des Oxidierens der ersten Metalllage vor dem Abscheiden der TiO₂-Schutzlage umfasst, um eine Metalloxidlage oben auf der Metalllage zu erhalten, wobei der Schritt des Oxidierens dadurch erfolgt, dass die Metalllage einer Atmosphäre, die aus O₂ oder aus einer Mischung von O₂ und einem oder mehreren Inertgasen besteht, wobei der Gesamt- oder Partialdruck von O₂ zwischen 0,13 Pa und 1333,22 Pa liegt, bei einer Temperatur zwischen 200 °C und 450 °C während einer Oxidationszeit zwischen 1 min und 30 min ausgesetzt wird.

4. Verfahren nach einem der vorstehenden Ansprüche, das ferner Prozessschritte zum Herstellen eines oder mehrerer Metall-Isolator-Metall-Kondensatorstrukturen auf dem Substrat umfasst.

## Revendications

1. Procédé de production d'un empilement de couches sur un substrat semiconducteur, le procédé comprenant les étapes de :
• fourniture d'un substrat (1),
• production sur ledit substrat d'une première couche de métal (2), ou d'une première couche de métal recouverte d'un oxyde dudit métal,
• par dépôt de couche atomique (ALD), dépôt sur ladite première couche de métal ou sur ledit oxyde d'une couche de protection (3) de TiO₂, dans lequel de l'H₂O est utilisé en tant qu'oxydant durant le dépôt ALD,
• par dépôt de couche atomique, dépôt sur ladite couche de TiO₂, d'une couche d'un matériau diélectrique, dans lequel de l'O₃ est utilisé en tant qu'oxydant durant le dépôt ALD, pour obtenir ainsi un empilement d'une couche de TiO₂ et d'une seconde couche diélectrique,
• dépôt d'une seconde couche de métal sur ladite couche de matériau diélectrique,
**caractérisé en ce que** ladite couche de TiO₂ de protection a une épaisseur inférieure à 1 nm, et dans lequel :
• la première couche de métal est constituée de ou comprend sur sa surface supérieure une couche de Ru ou une couche de Ru recouverte d'oxyde de ruthénium,
• la seconde couche diélectrique est une couche de TiO₂ en phase rutile.

2. Procédé selon la revendication 1, dans lequel un ou plusieurs dopants sont ajoutés à la seconde couche diélectrique, lesdits dopants étant choisis dans le groupe constitué de : Sr, Ta, Al, Hf, Gd, Zr, Sc, Dy.

3. Procédé selon la revendication 1 ou 2, comprenant l'étape de dépôt de ladite première couche de métal sur le substrat, suivie de l'étape d'oxydation de la première couche de métal avant le dépôt de la couche de TiO₂ de protection, de façon à obtenir une couche d'oxyde de métal au-dessus de la couche de métal, dans lequel ladite étape d'oxydation a lieu en soumettant la couche de métal à une atmosphère constituée d'O₂ ou d'un mélange d'O₂ et d'un ou plusieurs gaz inertes, avec la pression totale ou partielle d'O₂ entre 0,13 Pa et 1 333,22 Pa, à une température entre 200 °C et 450 °C, durant un temps d'oxydation entre 1 min et 30 min.

4. Procédé selon l'une quelconque des revendications précédentes, comprenant en outre des étapes de procédé pour produire une ou plusieurs structures de condensateur métal-isolant-métal sur le substrat.
